# FASCICULE DE BREVET EUROPEEN

(11) **EP 4 034 396 B1**
(45) Date de publication et mention de la délivrance du brevet: **21.02.2024**
(21) Numéro de dépôt: 20789651.5
(22) Date de dépôt: 22.09.2020
(51) Int. Cl.: B60H 1/22, F24H 3/04, H05B 3/50, B60H 1/32, H05B 3/06

(54) **BOITIER D'INTERFACE ÉLECTRONIQUE DE COMMANDE D'UN DISPOSITIF DE CHAUFFAGE ÉLECTRIQUE**
GEHÄUSE EINER ELEKTRONISCHEN SCHNITTSTELLE ZUR STEUERUNG EINER ELEKTRISCHEN HEIZVORRICHTUNG
ELECTRONIC INTERFACE HOUSING FOR CONTROLLING AN ELECTRIC HEATING DEVICE

(30) Priorité: 27.09.2019 FR 1910720
(43) Date de publication de la demande: 03.08.2022
(73) Titulaire: VALEO SYSTEMES THERMIQUES, 78320 Le Mesnil Saint-Denis (FR)
(72) Inventeur: GOGMOS, Erwan, 78320 Le Mesnil Saint-Denis (FR); COUAPEL, Yann, 78320 Le Mesnil Saint-Denis (FR); LEFLOCH, Jonathan, 78320 Le Mesnil Saint-Denis (FR)
(74) Mandataire: Valeo Systèmes Thermiques
(86) Numéro de dépôt international: PCT/FR2020/051643
(87) Numéro de publication internationale: WO 2021/058900

(56) Documents cités:
- EP-A1- 3 310 127
- DE-A1-102009 032 621
- FR-A1- 3 064 818
- KR-A- 20100 112 035

## Description

Le domaine de la présente invention est celui du chauffage de véhicule automobile. Elle concerne les dispositifs de chauffage électrique destinés à être montés dans une installation de ventilation, de chauffage et/ou de climatisation d'un véhicule automobile.

Plus particulièrement, l'invention concerne un dispositif de chauffage électrique comportant des modules chauffants par diffusion de chaleur sous l'effet d'un potentiel électrique, c'est-à-dire des éléments chauffants résistifs, par exemple des résistances à coefficient de température positif (CTP), qui permettent de produire rapidement de la chaleur dans les véhicules par le biais d'une alimentation électrique donnée.

On connait, par exemple du document DE 10 2009 032621 A1, la mise en oeuvre de tels dispositifs de chauffage électriques pour le chauffage d'un flux d'air traversant notamment un conduit d'une installation de ventilation, chauffage et/ou climatisation d'un véhicule automobile. Dans ce contexte, les dispositifs de chauffage électrique, ou radiateurs électriques, comportent un cadre ajouré configuré pour porter des modules chauffants par diffusion de chaleur sous l'effet d'un potentiel électrique de manière à ce que ces modules chauffants soient au contact de l'air traversant le cadre. Le cadre contient des compartiments permettant de recevoir au moins un module chauffant qui s'étend longitudinalement et qui peut être formé d'un tube à l'intérieur duquel sont logés des électrodes qui entourent les éléments chauffants résistifs. Les électrodes sont prolongées à l'extérieur du tube par des terminaux de connexion qui s'étendent vers des terminaux de raccordement, eux-mêmes reliés à une carte de circuits imprimés. Les terminaux de raccordement, la carte de circuits imprimés ainsi que les autres composants électroniques nécessaires au fonctionnement du dispositif de chauffage électrique, sont intégrés dans un boîtier d'interface électronique qui comprend une embase formant un logement de réception de ces composants et un capot qui vient en recouvrement pour les protéger.

L'évolution des technologies et des besoins thermiques des véhicules automobiles impliquent la mise en oeuvre de dispositifs de chauffage électriques alimentés en haute tension, de manière à faire délivrer par les éléments résistifs une puissance thermique susceptible de chauffer l'air passant dans l'installation de ventilation, chauffage et/ou climatisation sans qu'il soit nécessaire d'ajouter un échangeur thermique additionnel. Ces dispositifs à haut voltage nécessitent de prévoir des composants électroniques en plus grand nombre et de plus grandes dimensions, et cela s'accompagne d'un besoin d'un boitier d'interface électronique volumineux pour loger ces composants. Le fait d'avoir un boîtier d'interface électronique volumineux implique le fait d'avoir un capot avec une surface importante, qui rend possible le fléchissement du capot en son centre, à distance des moyens de fixation, notamment par encliquetage élastique, de ce capot sur l'embase. Il est dès lors connu de prévoir, entre le capot et la carte de circuit imprimés, des nervures rigides qui s'étendent de manière à être au contact de l'un et de l'autre, entre les composants électroniques fixés sur cette carte de circuits imprimés, afin de diminuer le risque de déformations du capot. Les nervures rigides agissent ainsi comme des supports du capot sur la carte de circuits imprimés empêchant ainsi le capot de se déformer sous certaines contraintes.

Par ailleurs, une fois le capot fixé sur l'embase, la carte de circuits imprimés et les composants électroniques sont logés dans un espace sensiblement clos délimités par l'embase et le capot. Le nombre de composants électroniques dans le boîtier d'interface électronique entraine un apport important de chaleur et une augmentation de la température à l'intérieur du capot, ce phénomène étant accru par l'alimentation à haut voltage évoquée précédemment. Afin de permettre le refroidissement des composants électroniques, le capot et/ou l'embase sont percés d'orifices, munis de membranes filtrantes, pour permettre le passage d'air et l'évacuation de calories. En contrepartie, de l'air frais et humide pénètre dans le logement et la chaleur dégagée par les composants peut générer une condensation de l'air humide et la formation de gouttes sur la face interne du capot.

Un ruissellement des gouttes peut se produire le long des nervures rigides, depuis la zone de contact de ces nervures avec le capot jusqu' à la zone de contact de ces nervures avec la carte de circuits imprimés. On comprend que la présence d'eau sur la carte de circuits imprimés équipée par ailleurs de composants électroniques peut générer des courts circuits ou à tout le moins une détérioration des composants.

Dans ce contexte, la présente invention a pour but de proposer un boîtier d'interface électronique d'un dispositif de chauffage qui permettent de prévenir des fléchissements importants du capot tout en empêchant l'accumulation d'eau sur la carte de circuits imprimés.

Dans ce but, la présente invention a tout d'abord pour objet un boitier d'interface électronique avec carte(s) de circuits imprimés d'un dispositif de chauffage électrique pour le chauffage d'un flux d'air traversant, le boîtier d'interface électronique étant configuré pour loger des composants électroniques de commande d'au moins un élément chauffant équipant le dispositif de chauffage électrique et parmi lesquels au moins la carte de circuits imprimés, le le boîtier d'interface électronique comprenant au moins une nervure en contact avec la carte de circuits imprimés au niveau d'une zone de contact, caractérisé en ce que la carte de circuits imprimés comporte au moins un orifice d'évacuation d'eau dans la zone de contact.

Le dispositif de chauffage électrique comprend deux blocs solidaires l'un de l'autre, chaque bloc ayant sa propre fonction. Un bloc est formé des éléments chauffants et a comme fonction principale de réchauffer l'air le traversant lorsque le dispositif de chauffage est allumé. L'autre bloc comprend le boîtier d'interface électronique assurant la commande électrique ainsi que l'apport énergétique du dispositif de chauffage électrique.

Le boîtier d'interface électronique est dimensionné pour loger les composants électroniques nécessaires au pilotage du dispositif de chauffage. L'un des éléments principaux des composants électroniques est la carte de circuits imprimés ayant comme fonction de relier entre eux, ou à tout le moins à un réseau électrique du véhicule, l'ensemble des composants électroniques du dispositif de chauffage électrique, comme par exemple, un élément de connexion d'un élément chauffant.

La carte de circuits imprimés est ainsi logée dans le boîtier d'interface électronique, en étant rendue solidaire, notamment à sa périphérie, d'une paroi de ce boîtier. La présence d'une nervure formant une saillie du boîtier et s'étendant jusqu'à la carte de circuits imprimés permet de rigidifier cet ensemble.

La caractéristique de l'invention selon laquelle la carte de circuits imprimés comprend au moins un orifice d'évacuation d'eau au niveau de la zone de contact entre la carte de circuits imprimés et la nervure permet d'assurer l'évacuation de l'eau stagnant le long de cette nervure du capot au niveau de la zone de contact avec la carte de circuits imprimés et permet ainsi d'éviter un court-circuit des composants électroniques portés par la carte de circuits imprimés et/ou une oxydation de ces composants.

Selon une caractéristique optionnelle de l'invention, l'orifice d'évacuation d'eau est dimensionné pour dépasser de la zone de contact.

Le diamètre, ou l'une des dimensions, de l'orifice d'évacuation d'eau est plus grand que la dimension correspondante, par exemple l'épaisseur, de la nervure au niveau de la zone de contact. L'orifice d'évacuation d'eau n'est ainsi pas recouvert intégralement par la nervure et du liquide peut passer à son travers pour être évacué de cette zone de contact entre nervure et carte de circuits imprimés.

Selon une caractéristique optionnelle de l'invention, l'orifice d'évacuation d'eau est débouchant sur chacune des faces de la carte de circuits imprimés.

On comprend que l'orifice d'évacuation d'eau est traversant de la carte de circuits imprimés au niveau de la zone de contact.

Selon une autre caractéristique optionnelle de l'invention, chaque zone de contact de la carte de circuits imprimés comprend au moins un orifice d'évacuation d'eau. Il est ainsi possible d'éviter l'accumulation d'eau sur chacune des nervures au contact de ces zones de contact.

Selon une caractéristique optionnelle de l'invention, le carte de circuits imprimés présente au moins un orifice de guidage au niveau de la zone de contact au niveau et l'orifice d'évacuation d'eau est distinct dudit orifice de guidage.

L'orifice de guidage ainsi prévu au niveau de la zone de contact est configuré pour loger un plot de guidage de l'une des nervures du capot et/ou de l'embase du boîtier d'interface électronique. Cet orifice de guidage permet de positionner le capot et/ou l'embase et la carte de circuits imprimés correctement lors du montage du dispositif de chauffage.

On comprend que l'orifice d'évacuation d'eau et l'orifice de guidage sont situés sur la carte de circuits imprimés au niveau de la zone de contact, et sont ainsi proches l'un de l'autre. Cependant, l'orifice d'évacuation d'eau et l'orifice de guidage ne sont pas communs, l'un n'assurant pas la fonction de l'autre et sont donc distincts l'un de l'autre. Plus particulièrement, l'orifice d'évacuation d'eau selon l'invention est spécifiquement réalisé pour cette fonction et il n'est pas destiné à recevoir un plot de guidage qui pourrait gêner l'évacuation d'eau.

Selon une caractéristique optionnelle de l'invention, la dimension de l'orifice d'évacuation d'eau est inférieure à la dimension correspondante de l'orifice de guidage.

Conformément à ce qui a été précédemment décrit, l'orifice d'évacuation d'eau a pour seule fonction cette évacuation d'eau et est donc dimensionné au plus juste pour que le liquide puisse passer à travers la carte de circuits imprimés, tandis que l'orifice de guidage doit être suffisamment grand pour recevoir un plot de guidage solidaire de la nervure formant la zone de contact.

Selon une caractéristique optionnelle de l'invention, l'orifice d'évacuation se situe plus au centre de la carte de circuits imprimés que l'orifice de guidage. On vise ainsi à évacuer en priorité la partie du liquide stagnant dans la zone de contact qui est le plus proche du centre et donc des composants électroniques massivement disposés au centre de la carte de circuits imprimés.

Selon une caractéristique optionnelle de l'invention, la carte de circuits imprimés comprend un premier orifice de guidage et un premier orifice d'évacuation d'eau s'alignant selon un premier axe d'alignement, et au moins un deuxième orifice de guidage et au moins un deuxième orifice d'évacuation d'eau s'alignant sur un deuxième axe d'alignement, caractérisé en ce que le premier axe d'alignement et le deuxième axe d'alignement sont perpendiculaires l'un à l'autre dans le plan d'extension de la carte de circuits imprimés.

On comprend que chaque ensemble formé par un orifice d'évacuation et un orifice de guidage est configuré géométriquement, dans l'alignement des orifices, en fonction de l'orientation de la nervure formant la zone de contact. Il est avantageux d'avoir deux nervures au contact de la carte de circuits imprimés qui sont agencées à distance l'une de l'autre et orientées dans des directions perpendiculaires, et dès lors un ensemble formé par un orifice d'évacuation et un orifice de guidage présente avantageusement une orientation, c'est-à-dire un axe d'alignement, sensiblement perpendiculaire à l'orientation d'un autre ensemble.

Selon une caractéristique optionnelle de l'invention, le boîtier d'interface électronique comporte une embase et un capot, la nervure formant saillie de l'embase et/ou du capot.

La nervure peut notamment former saillie du capot, et participer à rigidifier cet élément présentant la forme d'une plaque sensiblement plane. Le capot peut notamment être configuré de manière à présenter une portion périphérique de fixation à l'embase et une partie centrale de couverture des composants électroniques du boîtier logés dans l'embase, et la nervure destinée à être au contact de la carte de circuits imprimés étant issue de la partie centrale du capot.

Selon une caractéristique optionnelle de l'invention, l'orifice d'évacuation d'eau est agencé en regard de l'extrémité distale d'une première nervure issue du capot et en regard de l'extrémité distale d'une deuxième nervure issue de l'embase.

L'invention porte également sur un dispositif de chauffage comprenant au moins un élément chauffant et un boîtier d'interface électronique selon l'une quelconque des caractéristiques précitées.

D'autres caractéristiques, détails et avantages de l'invention ressortiront plus clairement à la lecture de la description qui suit d'une part, et de plusieurs exemples de réalisation donnés à titre indicatif et non limitatif en référence aux dessins schématiques annexés d'autre part, sur lesquels :
[Fig. 1] est une vue en perspective d'un dispositif de chauffage selon l'invention ;
[Fig. 2] est une coupe longitudinale de la vue en perspective du dispositif de chauffage de la figure 1, dans laquelle il a été notamment rendu visible la carte de circuits imprimés équipant le dispositif de chauffage, une nervure rigide du capot et une nervure rigide de l'embase enserrant cette carte de circuits imprimés, et un orifice d'évacuation d'eau formé dans la carte de circuits imprimés au droit de la nervure rigide du capot ;
[Fig. 3] est une représentation schématique de la carte de circuits imprimés, ici dépourvue de composants électroniques, comportant deux orifices d'évacuation d'eau agencés respectivement à côté d'un orifice de guidage ;
[Fig. 4] est une représentation partielle, selon une vue en coupe transversale, du boîtier d'interface électronique du dispositif de chauffage de la figure 1, ladite coupe transversale étant réalisée dans un plan comprenant une nervure rigide du capot et une nervure rigide de l'embase et rendant visible un orifice d'évacuation d'eau et un orifice de guidage ;
[Fig. 5] est une vue en perspective d'une coupe longitudinale de la figure 4.

Les caractéristiques, variantes et les différentes formes de réalisation de l'invention peuvent être associées les unes avec les autres, selon diverses combinaisons, dans la mesure où elles ne sont pas incompatibles ou exclusives les unes par rapport aux autres.

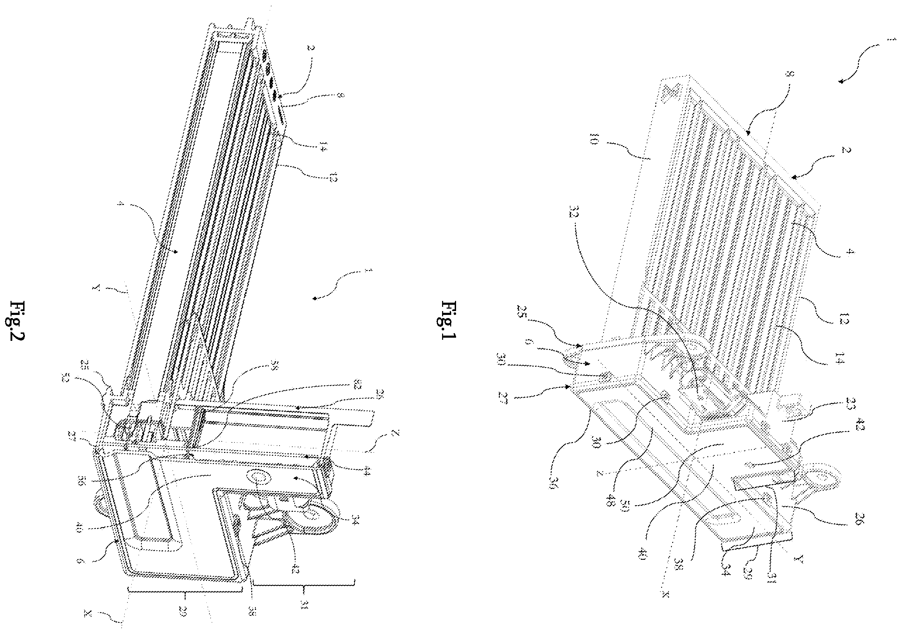

En se référant tout d'abord à la figure 1, un dispositif de chauffage électrique 1 selon l'invention comprend un corps de chauffe 2 comportant au moins un élément chauffant 4, et un boîtier d'interface électronique 6 rendu solidaire du corps de chauffe 2.

Le dispositif de chauffage électrique 1 est configuré pour être intégré au sein d'un boîtier d'une installation de ventilation, de chauffage et/ou d'air conditionné. Plus particulièrement, le dispositif de chauffage électrique est intégré dans une telle installation, avec le corps de chauffe 2 disposé à l'intérieur de l'installation, en travers d'un conduit de circulation d'un flux d'air, et avec le boîtier d'interface électronique accessible depuis l'extérieur du boîtier de cette installation. Le ou les éléments chauffants 4 présents dans le corps de chauffe permettent de chauffer l'air traversant le dispositif de chauffage électrique 1. Le boîtier d'interface électronique 6 contient l'ensemble des composants électroniques qui permettent à la fois de contrôler le fonctionnement et d'alimenter électriquement le dispositif de chauffage 1.

Le corps de chauffe 2 comporte ici un cadre formant structure de maintien des éléments chauffants. Il convient de noter que la présence d'un cadre n'est pas nécessaire selon l'invention et que ce qui va suivre au sujet du cadre n'est décrit qu'à titre illustratif, étant entendu que le corps de chauffe 2 pourrait consister en des éléments chauffants reliés au boîtier d'interface électronique 6 et non soutenus par un cadre.

Ici, le cadre est réalisé de façon monobloc, en un seul tenant, et il présente la forme d'un parallélépipède rectangle s'étendant principalement suivant un axe longitudinal X. Plus particulièrement, le cadre comprend une paroi de fond 8 qui s'étend à l'opposé du boîtier d'interface électronique 6 par rapport à l'au moins un élément chauffant 4 lorsque le dispositif de chauffage électrique 1 est assemblé. A chacune des extrémités transversales de la paroi de fond 8 est positionnée respectivement une première paroi latérale 10 et une deuxième paroi latérale 12, s'étendant perpendiculairement à la paroi de fond 8. La première paroi latérale 10 et la deuxième paroi latérale 12, disposées en regard l'une de l'autre, participent à délimiter transversalement le logement formé par le cadre du dispositif de chauffage électrique 1.

L'ensemble formé par la paroi de fond 8, la première paroi latérale 10 et la deuxième paroi latérale 12 présente une forme en U, où la paroi de fond 8 forme la base de la forme en U, le boîtier d'interface électronique 6 venant fermer l'ouverture de la forme en U lors de l'assemblage du dispositif de chauffage électrique 1.

Il résulte de cette configuration la présence de deux faces ajourées, respectivement délimitées par la paroi de fond, les parois latérales et le boîtier d'interface électronique, et susceptibles d'être traversées par le flux d'air lorsque le corps de chauffe 2 est disposé dans le boitier d'installation de ventilation, chauffage et/ou air conditionné. Le cadre, ici présent dans le corps de chauffe 2, présente une pluralité de barres longitudinales 14 qui s'étendent en travers des faces ajourées, parallèlement à la première paroi latérale 10 et la deuxième paroi latérale 12.

La paroi de fond 8, la première paroi latérale 10, la deuxième paroi latérale 12 et la pluralité de barres longitudinales 14 participent à former au moins un logement dans lequel vient se positionner au moins un élément chauffant 4 tel qu'il a été présenté ci-dessus.

L'au moins un élément chauffant 4 comporte des éléments résistifs alimentés électriquement pour qu'ils chauffent et ainsi participent à réchauffer le flux d'air traversant le dispositif de chauffage électrique 1. Ainsi, le au moins un élément chauffant 4 est connecté électriquement à un réseau électrique du véhicule via le boîtier d'interface électronique 6.

Le au moins un élément chauffant 4 s'étend suivant un axe longitudinal du dispositif de chauffage électrique 1, parallèlement à la première paroi latérale 10 et la deuxième paroi latérale 12.

Le boîtier d'interface électronique 6 comporte une embase 26 et un capot 34. L'embase est configurée pour loger des composants électroniques et la carte de circuits imprimés associée et le capot 34 est disposé en recouvrement de l'embase 26 afin de protéger ces composants es intempéries et des chocs par exemple. L'embase 26 et le capot 34 du boîtier d'interface électronique 6 contribue ainsi au logement et à la protection des composants électronique du boîtier d'interface électronique 6.

L'embase 26 comporte une face interne, non visible sur la figure 1 et tournée vers l'intérieur du boîtier d'interface électronique 6 et vers les composants électroniques, et une face externe 23.

L'embase 26 présente une partie longitudinale proximale 25 proche du corps de chauffe 2, susceptible de coopérer avec le corps de chauffe 2 pour permettre l'assemblage de l'un avec l'autre, et une partie longitudinale distale 27 éloignée du corps de chauffe 2, sur laquelle est fixé le capot 34.

Dans l'exemple illustré, l'embase 26 présente une forme en T comportant une première partie 29 s'étendant transversalement sensiblement sur toute la dimension transversale du corps de chauffe et une deuxième partie 31 prolongeant verticalement la première partie 29 sensiblement en son centre. La première partie 29 se situe dans le prolongement longitudinal du corps de chauffe 2 et participe à loger des moyens de raccordement électrique des éléments chauffants présents dans ce corps de chauffe, tandis que la deuxième partie 31 est décalée verticalement par rapport à la première partie 29 et au corps de chauffe.

Sur la deuxième partie 31 de l'embase 26 est notamment positionnée au moins une prise de raccordement électrique 32 permettant d'alimenter en courant électrique, notamment à haute tension, les composants électroniques du boîtier d'interface électronique 6 et les éléments résistifs de chacun des éléments chauffants.

L'embase 26 comprend sur sa face externe 23 et sur sa partie longitudinale distale 27 au moins un ergot 30. Le au moins un ergot 30 est dimensionné pour coopérer avec des moyens de fixation propres au capot 34 afin d'assurer la fixation réversible du capot sur l'embase 26.

Le capot 34 prend la forme d'une plaque qui vient en recouvrement de l'embase 26 notamment pour protéger les composants électroniques logés dans l'embase 26. A cet effet, le capot 34 présente une forme, ici en T, complémentaire de la forme de l'embase 26. Plus particulièrement, dans l'exemple illustré, le capot 34 comprend une première portion 48, présentant une forme et des dimensions équivalentes à celles de la première partie 29 de l'embase 26, et une deuxième portion 50, présentant une forme et des dimensions équivalentes à celles de la deuxième partie 31 de l'embase 26.

Le capot 34 s'étend principalement dans un plan comprenant un axe transversal Y et un axe vertical Z. De plus, on définit arbitrairement que le capot 34 est à l'avant du dispositif de chauffage électrique 1 selon l'axe longitudinal X et que la paroi de fond 8 est à l'arrière de dispositif de chauffage électrique 1 selon cet axe longitudinal X.

Le capot 34 comprend une portion périphérique 36, destinée à coopérer avec un bord périphérique complémentaire de l'embase pour la fixation du capot sur l'embase, et une partie centrale 40 permettant le recouvrement de l'embase. La portion périphérique 36 présente au moins une languette 38 qui s'étend perpendiculairement au plan du capot et dont la fonction est de fixer le capot 34 à l'embase 26 par complémentarité avec le ou les ergots 30 précédemment évoqués. On comprend que les ergots 30 et les languettes 38 coopèrent ici pour former des moyens d'encliquetage par déformation élastique.

Sur la partie centrale 40, ici au niveau de la deuxième portion 50, le capot comporte une ouverture d'aération 42, qui permet le refroidissement des composants électroniques intégrés dans le boîtier d'interface électronique 6 et éviter leur surchauffe.

Tel qu'illustré sur la figure 2, l'embase 26 et le capot 34 logent différents composants électroniques dont une carte de circuits imprimés 44. La carte de circuits imprimés 44 présente une face arrière 51, tournée vers le corps de chauffe 2, et une face avant 53, tournée vers le capot 34, ces faces avant et arrière étant définies ainsi selon le référentiel choisi arbitrairement. La carte de circuits imprimés 44 porte une pluralité de composants électroniques et intègre des pistes de cuivre pour l'alimentation et l'envoi d'instructions de commande de ces composants, ici non visibles, la carte de circuits imprimés permettant ainsi d'assurer la commande électronique des éléments chauffants du dispositif de chauffage électrique selon l'invention.

La carte de circuits imprimés 44 est notamment configurée pour être rendue solidaire d'au moins un élément de connexion 52 solidaire d'un élément chauffant 4, de manière à assurer la liaison électrique nécessaire au passage de courant pour que cet élément chauffant 4 produise de la chaleur.

La face avant 53 de la carte de circuits imprimés 44 est en contact d'au moins une première nervure rigide 56 issue du capot 34 au niveau d'une première zone de contact 54. La première nervure rigide 56 s'étend longitudinalement, sensiblement perpendiculairement au plan du capot 34. Dans l'exemple illustré, la première nervure rigide 56 s'étend principalement longitudinalement le long de l'axe longitudinal X et transversalement le long de l'axe transversal Y.

La première nervure rigide 56 comprend une première extrémité distale 57, ou autrement dit une extrémité libre à distance du capot dont elle fait saillie, la première nervure rigide 56 étant en contact avec la carte de circuits imprimés 44 au niveau de cette première extrémité distale 57 pour former la première zone de contact 54 précédemment évoquée.

Dans l'exemple illustré, dans cette première zone de contact 54, la face arrière 51 de la carte de circuits imprimés 44 est en contact d'au moins une deuxième nervure rigide 58 issue de l'embase 26. Conformément à ce qui a été décrit pour la première nervure rigide 56, la deuxième nervure rigide 58 s'étend longitudinalement, sensiblement perpendiculairement au plan défini par le fond de l'embase 26. Dans l'exemple illustré, la deuxième nervure rigide 58 s'étend principalement longitudinalement le long de l'axe longitudinal X et transversalement le long de l'axe transversal Y.

La deuxième nervure rigide 58 comprend une deuxième extrémité distale 60, ou autrement dit une extrémité libre à distance du fond de l'embase dont elle fait saillie, la deuxième nervure rigide 58 étant en contact avec la carte de circuits imprimés 44 au niveau de cette deuxième extrémité distale 60.

La première nervure 56 du capot 34 et la deuxième nervure 58 de l'embase 26 sont ainsi situées de part et d'autre de la carte de circuits imprimés 44 au niveau de la première zone de contact 54 et sont agencées de manière à enserrer la carte de circuits imprimés. La première nervure 56 du capot 34 est orientée de façon identique avec la deuxième nervure 58 de l'embase 26, notamment ici selon l'axe transversal Y. La première nervure 56 du capot 34 et la deuxième nervure 58 de l'embase 26 enserrent la carte de circuit imprimés 44 en évitant le déplacement de la carte de circuits imprimés 44 le long de l'axe longitudinal X. Les coupes de la première nervure rigide 56 et la deuxième nervure rigide 58 sont représentées par des zones hachurées sur l'ensemble des figures 2, 4 et 5.

Indépendamment de cette prise en sandwich de la carte de circuits imprimés entre deux nervures rigides, il convient de noter que la première nervure 56 du capot 34 venant reposer contre la carte de circuits imprimés permet d'éviter le fléchissement du capot en son centre, par une reprise d'efforts sur la carte de circuits imprimés, plus rigide que le capot et par ailleurs fermement fixée dans l'embase.

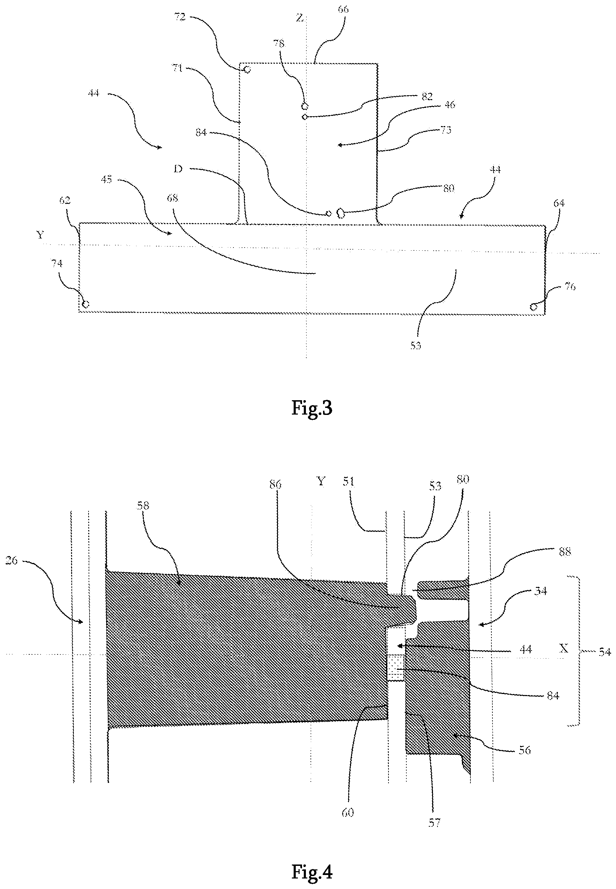

Tel qu'illustré sur la figure 3, la carte de circuits imprimés 44 s'étend sous la forme d'un T complémentaire aux formes du capot 34 et de l'embase 26. La carte de circuits imprimés présente une partie primaire 45 s'étendant le long de l'axe transversal Y, entre un premier bord d'extrémité transversal 62 et un deuxième bord d'extrémité transversal 64, et une partie secondaire 46 qui prolonge la partie primaire sensiblement en son centre principalement selon la direction verticale Z et qui présente un bord d'extrémité verticale 66.

La partie secondaire 46 s'étend sous la forme d'un rectangle ayant comme côté, outre le bord de jonction D avec la partie primaire 45, représenté en pointillé sur la figure 3, un premier bord latéral 71, un deuxième bord latéral 73 et le bord d'extrémité verticale 66.

La carte de circuits imprimés 44 comprends plusieurs orifices débouchant sur la face arrière 51 et/ou sur la face avant 53, parmi lesquels on distingue des orifices de fixation 72, 74, 76, des orifices de guidage 78, 80 et des orifices d'évacuation d'eau 82, 84.

Plus particulièrement, la carte de circuits imprimés comprend au moins un premier orifice de fixation 72, un deuxième orifice de fixation 74 et un troisième orifice de fixation 76, débouchant sur la face arrière 51 et/ou sur la face avant 53 et destinés à être traversés par des éléments de fixation non représentés pour rendre solidaire la carte de circuits imprimés 44 du capot 34 et de l'embase 26 du boîtier d'interface électronique 6.

Le premier orifice de fixation 72, le deuxième orifice de fixation 74 et un troisième orifice de fixation 76 sont avantageusement circulaires et de même diamètre.

Le premier orifice de fixation 72 est situé sur la partie secondaire 46 de la carte de circuits imprimés 44, ici tel qu'illustré au niveau d'un coin formé par le bord d'extrémité verticale 66 et un bord latéral 71 de la partie secondaire 46.

Le deuxième orifice de fixation 74 et le troisième orifice de fixation 76 sont situés sur la partie primaire 45 de la carte de circuits imprimés 44, respectivement ici au niveau de la jonction d'un bord d'extrémité transversal 62, 64 et d'un bord d'extrémité vertical opposé au premier bord d'extrémité verticale 66 de la partie secondaire 46.

Selon l'invention, la carte de circuits imprimés comporte au moins un orifice d'évacuation d'eau. Plus particulièrement, la carte de circuits imprimés 44, ici au niveau de la partie secondaire 46, comprend au moins un premier orifice de guidage 78 et au moins un premier orifice d'évacuation d'eau 82 disposé à proximité de ce premier orifice de guidage. Dans le mode de réalisation décrit, la carte de circuits imprimés comprend également un deuxième orifice de guidage 80 et un deuxième orifice d'évacuation d'eau 84, également agencés dans la partie secondaire 46. On comprend de ce qui va suivre que chaque orifice d'évacuation d'eau prévu selon l'invention est associé à un orifice de guidage, c'est-à-dire disposé à proximité de cet orifice de guidage, sans que cela soit limitatif de l'invention, dès lors que la carte de circuits imprimés est équipé d'un orifice d'une part agencé près d'une nervure issue du capot et formant une zone de contact entre capot et carte de circuits imprimés et d'autre part dont la seule fonction est d'évacuer l'eau de condensation susceptible de stagner sur la carte de circuits imprimés après avoir coulé le long de cette nervure.

Dans l'exemple illustré, le premier orifice de guidage 78 est de forme circulaire et présente un premier diamètre. Le premier orifice de guidage 78 est avantageusement centré entre les bords latéraux 71, 73 de la partie secondaire 46 de la carte de circuits imprimés 44, en étant agencé verticalement plus proche du bord d'extrémité verticale 66 que du bord de jonction D. Le premier orifice de guidage 78 est configuré, en forme et en dimensions, pour recevoir un plot de guidage, visible sur les figures 4 à 6 formant saillie de la deuxième nervure rigide 58 solidaire de l'embase 26.

Le premier orifice d'évacuation d'eau 82 est également de forme circulaire et présente un deuxième diamètre plus petit que le premier diamètre du premier orifice de guidage 78. Le premier orifice d'évacuation d'eau 82 est ménagé à proximité du premier orifice de guidage 78, ici en étant aligné avec le premier orifice de guidage 78 selon l'axe vertical Z, correspondant tel que cela sera décrit ci-après en référence aux figures 4 à 6 à l'orientation principale de la première nervure rigide 56. Plus précisément, le premier orifice d'évacuation d'eau 82 et le premier orifice de guidage sont alignés de sorte que le premier orifice de guidage est situé plus à l'extérieur de la carte de circuits imprimés, c'est-à-dire ici plus proche du bord d'extrémité vertical 66, que le premier orifice d'évacuation d'eau 82. En d'autres termes, le premier orifice d'évacuation d'eau 82 prend une position plus centrale que le premier orifice de guidage 78.

Le deuxième orifice de guidage 80 est positionné de l'autre côté de la partie secondaire 46 par rapport au premier orifice de guidage, c'est-à-dire plus proche du bord de jonction D que du bord d'extrémité transversale 66. Le deuxième orifice de guidage présente ici une forme oblongue, avec une dimension principale définie par un axe passant sensiblement par le centre du premier orifice de guidage et une dimension secondaire, plus petite, perpendiculaire à cette dimension principale. Le deuxième orifice de guidage 80 est ici décalé transversalement, selon l'axe transversal Y, par rapport au centre le partie secondaire 46. Le deuxième orifice de guidage est également destiné à recevoir un plot de guidage formé en bout d'une nervure rigide issue de l'embase 26.

Le deuxième orifice d'évacuation d'eau 84 est circulaire et présente un troisième diamètre ici plus petit que la dimension secondaire du deuxième orifice de guidage 80. Le deuxième orifice d'évacuation d'eau 84 est ici aligné transversalement, selon l'axe transversal Y, avec le deuxième orifice de guidage 80. Le deuxième orifice d'évacuation d'eau 84 est ménagé à proximité du deuxième orifice de guidage 80, en étant, conformément à ce qui a été évoqué pour le premier orifice d'évacuation d'eau 82, plus proche du centre de la partie secondaire 46 que ne l'est le deuxième orifice de guidage 80.

Le premier orifice d'évacuation d'eau 82 et le deuxième orifice d'évacuation d'eau 84 sont représentés par des zones tachetées sur l'ensemble des figures 2, 4, 5 et 6.

Selon l'invention, chaque orifice d'évacuation d'eau est disposé dans la zone de contact formée par le contact de la première nervure rigide issue du capot avec la carte de circuits imprimés. Et cet orifice d'évacuation d'eau est dimensionné pour permettre le passage d'eau à travers la carte de circuits imprimés, et donc pour n'être que partiellement recouvert le cas échéant par la première nervure dans cette zone de contact.

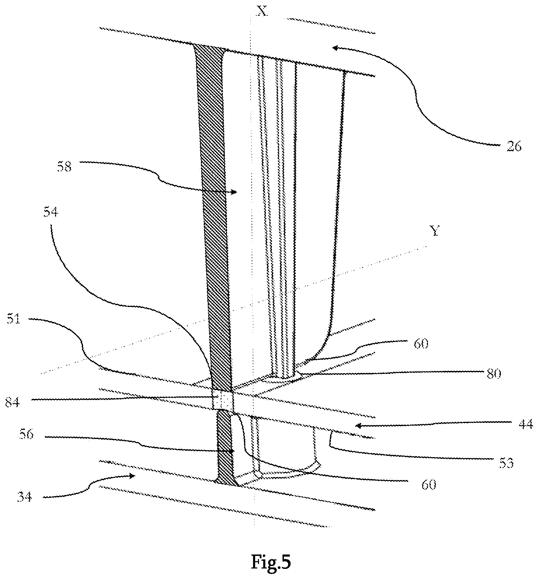

Dans l'exemple décrit, et notamment illustré sur les figures 4 et 5, le deuxième orifice de guidage 80 et le deuxième orifice d'évacuation d'eau 84 sont positionnés dans la première zone de contact 54 où la première nervure rigide 56 du capot 34 est en contact avec la face avant 53 de la carte de circuits imprimés 44. Il convient de noter que, dans le mode de réalisation illustré et sans que cela soit limitatif de l'invention, la deuxième nervure rigide 58 de l'embase 26 est en contact avec la face arrière 51 de la carte de circuits imprimés 44 également dans cette première zone de contact, et que dès lors, le deuxième orifice d'évacuation d'eau 84 est agencé entre les deux nervures rigides.

La deuxième nervure rigide 58 comprend au niveau de sa deuxième extrémité distale 60 un plot de guidage 86. Le plot de guidage 86 s'étend longitudinalement le long de l'axe longitudinal X en prolongeant la deuxième nervure rigide 58 vers l'avant du dispositif de chauffage électrique 1 selon le référentiel choisi arbitrairement. Le plot de guidage 86 est destiné à se loger dans le deuxième orifice de guidage 80. Le diamètre mesuré à la base du plot de guidage 86 est plus petit que la dimension secondaire du deuxième orifice de guidage. En effet, lors du montage du dispositif de chauffage électrique 1, le plot de guidage 86 de la deuxième nervure rigide 58 de l'embase 26 est logé dans le deuxième orifice de guidage 80 de la carte de circuits imprimés dans le but de positionner correctement la carte de circuits imprimés 44 dans le boîtier d'interface électronique 6. La forme oblongue du deuxième orifice de guidage 80 permet le coulissement du plot de guidage dans cet orifice le long de la direction principale et permet ainsi d'ajuster la position de la carte de circuits imprimés par rapport à l'embase, et la forme circulaire du premier orifice de guidage 78 permet de figer cette position ajustée.

Comme représenté sur la figure 4, la longueur longitudinale du plot de guidage 86 est plus grande que l'épaisseur de la carte de circuits imprimés 44, mesurée également selon l'axe longitudinal X, de sorte qu'une extrémité libre 87 du plot de guidage 86 dépasse de la face avant 53 de la carte de circuits imprimés 44.

Pour rappel, la première nervure rigide 56 du capot 34 et la deuxième nervure rigide 58 de l'embase 26 sont alignées l'une par rapport à l'autre de part et d'autre de la carte de circuits imprimés. La première nervure rigide 56 du capot 34 présente un évidement 88 destiné à libérer suffisamment d'espace pour ne pas être en contact avec l'extrémité libre 87. Il en résulte que la première nervure rigide 56 n'est pas en contact avec la première zone de contact 54 au niveau du deuxième orifice de guidage 80.

Au niveau de l'orifice d'évacuation d'eau, ici le deuxième orifice d'évacuation d'eau 84, la première nervure rigide 56 du capot 34 et la deuxième nervure rigide 58 de l'embase 26 sont en contact avec la première zone de contact 54 de la carte de circuits imprimés 44. La première nervure rigide 56 recouvre une majeure partie du deuxième orifice d'évacuation d'eau 84 sur la face avant 53 de la carte de circuits imprimés 44. La deuxième nervure rigide 58 recouvre une majeure partie du deuxième orifice d'évacuation d'eau 84 sur la face arrière 51 de la carte de circuits imprimés 44.

Il résulte de ce qui précède que l'orifice d'évacuation d'eau formé dans la carte de circuits imprimés selon l'invention est dimensionné pour ne pas être entièrement recouvert par l'une ou l'autre des nervures, de manière à laisser passage à l'eau pour l'évacuer de la carte de circuits imprimés. En d'autres termes, et tel qu'illustré sur la figure 5, le diamètre d'un orifice d'évacuation d'eau selon l'invention, ici le troisième diamètre du deuxième orifice d'évacuation d'eau 84, est plus grand que l'épaisseur de la nervure rigide correspondante au niveau de son extrémité distale au contact de la carte de circuits imprimés, ici l'épaisseur de la première nervure rigide 56 au niveau de la première extrémité distale 57. Et le cas échéant, dans le cas d'une présence d'une deuxième nervure rigide de l'autre côté de la carte de circuits imprimés, le diamètre de l'orifice d'évacuation d'eau est alors plus grand également que l'épaisseur de la deuxième nervure rigide au niveau de la deuxième extrémité distale. Ainsi, l'orifice d'évacuation d'eau, ici le deuxième orifice d'évacuation d'eau 84, dépasse de part et d'autre de la zone de contact de la nervure rigide correspondante avec la carte de circuits imprimés, ici de part et d'autre de la première zone de contact 54 de la première nervure rigide 56 avec la carte de circuits imprimés 44.

De la sorte, le deuxième orifice d'évacuation d'eau 84 évite la stagnation d'eau au niveau de la première zone de contact 54 de la première nervure rigide 56 et la deuxième nervure rigide 58 avec la carte de circuits imprimés 44. Plus généralement, chaque orifice d'évacuation d'eau formé dans la carte de circuits imprimés permet d'éviter la stagnation d'eau au niveau de la zone de contact entre la nervure rigide issue du capot et la carte de circuits imprimés.

L'eau qui se forme sur la face interne du capot, lorsque la température à l'intérieur du boîtier d'interface électronique 6 augmente et que l'air chaud chargé d'humidité entre en contact avec le capot soumis lui à la température de l'air extérieur, coule le long de la nervure rigide issue du capot vers la zone de contact de cette nervure rigide avec la carte de circuits imprimés, puis à travers l'orifice d'évacuation d'eau, entrainé par la gravité.

Il convient de noter que tout ce qui vient d'être décrit, en relation avec le deuxième orifice d'évacuation d'eau et les nervures correspondantes destinées à être en contact avec la carte de circuits imprimés dans une zone de contact dans laquelle s'étend ce deuxième orifice d'évacuation d'eau, s'applique sans restriction au premier orifice d'évacuation d'eau dans la zone de contact qui lui est propre.

L'invention telle qu'elle vient d'être décrite permet de résoudre les problèmes techniques évoqués précédemment, à savoir proposer un dispositif de chauffage électrique dans lequel le capot est moins soumis à des déformations du fait de la présence d'une nervure rigide entre le capot et une carte de circuits imprimés logée dans le boîtier d'interface électronique et dans lequel la présence de cette nervure rigide n'implique pas une stagnation d'eau le long de la carte de circuits imprimés contre cette nervure.

Il convient de noter que dans ce qui a été précédemment décrit, l'orifice d'évacuation d'eau est ménagé dans la carte de circuits imprimés dans une zone de contact formée par le contact de cette carte de circuits imprimés avec une nervure rigide issue de préférence du capot, ce qui est notamment intéressant lorsque le capot est dans une position surplombant la carte de circuits imprimés lorsque le dispositif de chauffage électrique est disposé dans le boîtier d'installation de ventilation, de chauffage et/ou d'air conditionné, et que les gouttes d'eau dues à la condensation ont tendance à se diriger du capot vers l'embase sous l'effet de la gravité. On comprend que sans sortir du contexte de l'invention, l'orifice d'évacuation pourrait être ménagé dans la carte de circuits imprimés dans une zone de contact formée par le contact de cette carte de circuits imprimés avec une nervure rigide issue de l'embase, sans être en regard d'une nervure rigide issue du capot, si c'est l'embase qui est dans une position surplombant la carte de circuits imprimés lorsque le dispositif de chauffage électrique est disposé dans le boîtier d'installation de ventilation, de chauffage et/ou d'air conditionné, et que les gouttes d'eau dues à la condensation ont tendance à se diriger de l'embase vers le capot sous l'effet de la gravité.

## Revendications

1. Boîtier d'interface électronique (6) avec carte(s) de circuits imprimés (44), d'un dispositif de chauffage électrique (1) pour le chauffage d'un flux d'air traversant, le boîtier d'interface électronique (6) étant configuré pour loger des composants électroniques de commande d'au moins un élément chauffant (4) équipant le dispositif de chauffage électrique (1) et parmi lesquels la carte de circuits imprimés (44), le boîtier d'interface électronique (6) comprenant au moins une nervure (56, 58) en contact avec la carte de circuits imprimés (44) au niveau d'une zone de contact (54), **caractérisé en ce que** la carte de circuits imprimés (44) comporte au moins un orifice d'évacuation d'eau (82, 84) dans la zone de contact (54).

2. Boîtier d'interface électronique (6) avec carte(s) de circuits imprimés (44), selon la revendication 1, dans lequel l'orifice d'évacuation d'eau (82, 84) est dimensionné pour dépasser de la zone de contact (54).

3. Boîtier d'interface électronique (6) avec carte(s) de circuits imprimés (44), selon l'une quelconque des revendications précédentes, dans lequel l'orifice d'évacuation d'eau (82, 84) est débouchant sur chacune des faces (51, 53) de la carte de circuits imprimés (44).

4. Boîtier d'interface électronique (6) avec carte(s) de circuits imprimés (44), selon l'une quelconque des revendications précédentes, dans lequel chaque zone de contact (54) de la carte de circuits imprimés (44) comprend au moins un orifice d'évacuation d'eau (82, 84).

5. Boîtier d'interface électronique (6) avec carte(s) de circuits imprimés (44), selon l'une quelconque des revendications précédentes, dans lequel la carte de circuits imprimés (44) présente au moins un orifice de guidage (78, 80) au niveau de la zone de contact (54), l'orifice d'évacuation d'eau (82, 84) étant distinct dudit orifice de guidage (78, 80).

6. Boîtier d'interface électronique (6) avec carte(s) de circuits imprimés (44), selon la revendication 5, dans lequel la dimension de l'orifice d'évacuation d'eau (82, 84) est inférieure à la dimension correspondante de l'orifice de guidage (78, 80).

7. Boîtier d'interface électronique (6) avec carte(s) de circuits imprimés (44), selon les revendications 5 ou 6, dans lequel l'orifice d'évacuation (82, 84) se situe plus au centre de la carte de circuits imprimés (44) que l'orifice de guidage (78, 80).

8. Boîtier d'interface électronique (6) avec carte(s) de circuits imprimés (44), selon l'une quelconque des revendications 5 à 7, dans lequel la carte de circuits imprimés (44) comprend un premier orifice de guidage (78) et un premier orifice d'évacuation d'eau (82) s'alignant selon un premier axe d'alignement, et au moins un deuxième orifice de guidage (80) et au moins un deuxième orifice d'évacuation d'eau (84) s'alignant selon un deuxième axe d'alignement, le premier axe d'alignement et la deuxième axe d'alignement étant perpendiculaires l'un à l'autre dans le plan d'extension de la carte de circuits imprimés (44).

9. Boîtier d'interface électronique (6) avec carte(s) de circuits imprimés (44), selon l'une des revendications précédentes et comportant une embase (26) et un capot (34), ladite nervure (56, 58) formant saillie de l'embase et/ou du capot (34).

10. Boîtier d'interface électronique (6) avec carte(s) de circuits imprimés (44), selon la revendication précédente, dans lequel l'orifice d'évacuation d'eau (82, 84) est agencé en regard de l'extrémité distale d'une première nervure (56) issue du capot (34) et en regard de l'extrémité distale d'une deuxième nervure (56) issue de l'embase (26).

11. Dispositif de chauffage électrique (1) comprenant au moins un élément chauffant (4) et un boîtier d'interface électronique (6) avec carte(s) de circuits imprimés (44), selon l'une quelconque des revendications précédentes.

## Patentansprüche

1. Gehäuse einer elektronischen Schnittstelle (6) mit einer oder mehreren Leiterplatten (44), einer elektrischen Heizvorrichtung (1) zum Heizen eines Durchgangsluftstroms, wobei das Gehäuse einer elektronischen Schnittstelle (6) dazu konfiguriert ist, elektronische Komponenten zur Steuerung mindestens eines Heizelements (4), mit dem die elektrische Heizvorrichtung (1) ausgerüstet ist, und zu denen die Leiterplatte (44) zählt, aufzunehmen, wobei das Gehäuse einer elektronischen Schnittstelle (6) mindestens einen Steg (56, 58) beinhaltet, der in einem Kontaktbereich (54) mit der Leiterplatte (44) in Kontakt ist, **dadurch gekennzeichnet, dass** die Leiterplatte (44) mindestens eine Wasserabfuhröffnung (82, 84) in dem Kontaktbereich (54) umfasst.

2. Gehäuse einer elektronischen Schnittstelle (6) mit einer oder mehreren Leiterplatten (44) nach Anspruch 1, wobei die Wasserabfuhröffnung (82, 84) so bemessen ist, dass sie über den Kontaktbereich (54) hinausragt.

3. Gehäuse einer elektronischen Schnittstelle (6) mit einer oder mehreren Leiterplatten (44) nach einem beliebigen der vorhergehenden Ansprüche, wobei die Wasserabfuhröffnung (82, 84) auf jeder der Seiten (51, 53) der Leiterplatte (44) mündet.

4. Gehäuse einer elektronischen Schnittstelle (6) mit einer oder mehreren Leiterplatten (44) nach einem beliebigen der vorhergehenden Ansprüche, wobei jeder Kontaktbereich (54) der Leiterplatte (44) mindestens eine Wasserabfuhröffnung (82, 84) beinhaltet.

5. Gehäuse einer elektronischen Schnittstelle (6) mit einer oder mehreren Leiterplatten (44) nach einem beliebigen der vorhergehenden Ansprüche, wobei die Leiterplatte (44) im Kontaktbereich (54) mindestens eine Führungsöffnung (78, 80) aufweist, wobei sich die Wasserabfuhröffnung (82, 84) von der Führungsöffnung (78, 80) unterscheidet.

6. Gehäuse einer elektronischen Schnittstelle (6) mit einer oder mehreren Leiterplatten (44) nach Anspruch 5, wobei die Abmessung der Wasserabfuhröffnung (82, 84) kleiner als die entsprechende Abmessung der Führungsöffnung (78, 80) ist.

7. Gehäuse einer elektronischen Schnittstelle (6) mit einer oder mehreren Leiterplatten (44) nach den Ansprüchen 5 oder 6, wobei sich die Abfuhröffnung (82, 84) weiter in der Mitte der Leiterplatte (44) befindet als die Führungsöffnung (78, 80).

8. Gehäuse einer elektronischen Schnittstelle (6) mit einer oder mehreren Leiterplatten (44) nach einem beliebigen der Ansprüche 5 bis 7, wobei die Leiterplatte (44) eine erste Führungsöffnung (78) und eine erste Wasserabfuhröffnung (82), die sich nach einer ersten Ausrichtungsachse ausrichten, und mindestens eine zweite Führungsöffnung (80) und mindestens eine zweite Wasserabfuhröffnung (84), die sich nach einer zweiten Ausrichtungsachse ausrichten, beinhaltet, wobei die erste Ausrichtungsachse und die zweite Ausrichtungsachse in der Ausdehnungsebene der Leiterplatte (44) zueinander senkrecht sind.

9. Gehäuse einer elektronischen Schnittstelle (6) mit einer oder mehreren Leiterplatten (44) nach einem der vorhergehenden Ansprüche, umfassend eine Basis (26) und eine Abdeckung (34), wobei der Steg (56, 58) einen Vorsprung der Basis und/oder der Abdeckung (34) bildet.

10. Gehäuse einer elektronischen Schnittstelle (6) mit einer oder mehreren Leiterplatten (44) nach dem vorhergehenden Anspruch, wobei die Wasserabfuhröffnung (82, 84) gegenüber dem distalen Ende eines ersten Stegs (56), der aus der Abdeckung (34) hervorgeht, und gegenüber dem distalen Ende eines zweiten Stegs (56), der aus der Basis (26) hervorgeht, angeordnet ist.

11. Elektrische Heizvorrichtung (1), die mindestens ein Heizelement (4) und ein Gehäuse einer elektronischen Schnittstelle (6) mit einer oder mehreren Leiterplatten (44) nach einem beliebigen der vorhergehenden Ansprüche beinhaltet.

## Claims

1. Electronic interface housing (6) with printed circuit board(s) (44) of an electrical heating device (1) for heating an airflow passing through it, the electronic interface housing (6) being configured to house electronic components for controlling at least one heating element (4) fitted to the electrical heating device (1), including the printed circuit board (44), the electronic interface housing (6) comprising at least one rib (56, 58) in contact with the printed circuit board (44) at a contact zone (54), **characterized in that** the printed circuit board (44) comprises at least one water discharge opening (82, 84) in the contact zone (54).

2. Electronic interface housing (6) with printed circuit board(s) (44) according to Claim 1, wherein the water discharge opening (82, 84) is dimensioned to extend beyond the contact zone (54).

3. Electronic interface housing (6) with printed circuit board(s) (44) according to either one of the preceding claims, wherein the water discharge opening (82, 84) opens out on each of the sides (51, 53) of the printed circuit board (44).

4. Electronic interface housing (6) with printed circuit board(s) (44) according to any one of the preceding claims, wherein each contact zone (54) of the printed circuit board (44) comprises at least one water discharge opening (82, 84).

5. Electronic interface housing (6) with printed circuit board(s) (44) according to any one of the preceding claims, wherein the printed circuit board (44) comprises at least one guiding opening (78, 80) at the contact zone (54), the water discharge opening (82, 84) being separate from said guiding opening (78, 80).

6. Electronic interface housing (6) with printed circuit board(s) (44) according to Claim 5, wherein the size of the water discharge opening (82, 84) is smaller than the corresponding size of the guiding opening (78, 80) .

7. Electronic interface housing (6) with printed circuit board(s) (44) according to Claims 5 or 6, wherein the discharge opening (82, 84) is located closer to the centre of the printed circuit board (44) than the guiding opening (78, 80).

8. Electronic interface housing (6) with printed circuit board(s) (44) according to any one of Claims 5 to 7, wherein the printed circuit board (44) comprises a first guiding opening (78) and a first water discharge opening (82) in alignment along a first alignment axis, and at least a second guiding opening (80) and at least a second water discharge opening (84) in alignment along a second alignment axis, the first alignment axis and the second alignment axis being perpendicular to one another in the plane of extension of the printed circuit board (44) .

9. Electronic interface housing (6) with printed circuit board(s) (44) according to one of the preceding claims and comprising a base (26) and a cover (34), said rib (56, 58) forming a projection from the base and/or the cover (34).

10. Electronic interface housing (6) with printed circuit board(s) (44) according to the preceding claim, wherein the water discharge opening (82, 84) is arranged opposite the distal end of a first rib (56) starting from the cover (34) and opposite the distal end of a second rib (56) starting from the base (26).

11. Electrical heating device (1) comprising at least one heating element (4) and an electronic interface housing (6) with printed circuit board(s) (44) according to any one of the preceding claims.
